Europäisches Patentamt

European Patent Office

Office européen des brevets

(11) Veröffentlichungsnummer: **0 372 096**
**A1**

## EUROPÄISCHE PATENTANMELDUNG

(21) Anmeldenummer: 88119828.7

(22) Anmeldetag: 28.11.88

(51) Int. Cl.5: **G01R 33/20**

(43) Veröffentlichungstag der Anmeldung:
**13.06.90 Patentblatt 90/24**

(84) Benannte Vertragsstaaten:
**DE FR GB**

(71) Anmelder: **Siemens Aktiengesellschaft
Wittelsbacherplatz 2
D-8000 München 2(DE)**

(72) Erfinder: **Siebold, Horst, Dr.
Reuthlehenstrasse 63
D-8520 Erlangen(DE)**

(54) **Gradientenspulen-System für einen Kernspintomographen.**

(57) Die Erfindung bezieht sich auf ein Gradientenspulen-System mit x- und y-Hauptspulen in der Ausführungsform als Sattelspulen mit aufgeteiltem inneren Bogen (split arc saddle coils). Die Spulenbogen so aufgeteilt sind, daß ihre Durchflutung mit zunehmendem Abstand von der Symmetrieebene zunimmt. Erfindungsgemäß sind den y- und x-Hauptspulen (10, 11 und 12, 13) jeweils y- und x-Zusatzspulen (23, 24 bzw. 25, 26) zugeordnet, die ebenfalls als Sattelspulen ausgebildet sind und deren Öffnungswinkel kleiner als 90° ist und die auf der gleichen Zylinderfläche mit dem Radius $\rho_3$ angeordnet sind. Die das Gradientenfeld bestimmenden Größen der Elementarsattelspulen sind so aufeinander abgestimmt, daß die Störterme ($C_{n,m}$) der Reihenentwicklung des Gradientenfeldes wenigstens teilweise eliminiert werden.

FIG 4

EP 0 372 096 A1

## Gradientenspulen-System für einen Kernspintomographen

Die Erfindung bezieht sich auf ein Gradientenspulen-System für einen Kernspintomographen, dessen Symmetrieebene in der x-y-Ebene eines rechtwinkligen x-y-z-Koordinatensystems liegt, dessen z-Achse in Richtung eines magnetischen Grundfeldes $B_z$ verläuft. Dem magnetischen Grundfeld $B_z$ ist eine Sattelspulenanordnung für ein x-Gradientenfeld und eine Sattelspulenanordnung für ein y-Gradientenfeld zugeordnet. Diese Sattelspulenanordnungen enthalten jeweils vier Hauptspulen, die aus Sattelspulen mit aufgeteiltem inneren Bogen (split arc saddle coils) bestehen und auf Zylindermantelflächen angeordnet sind. Die Hauptspulen bestehen jeweils aus zwei ineinanderliegenden Elementarsattelspulen, jede Elementarsattelspule enthält einen der x-y-Ebene zugewandten, vorderen Bogen mit dem Abstand Z von der x-y-Ebene und einen hinteren Bogen mit dem Abstand H. Die Bogen sind durch in z-Richtung verlaufende gerade Leiterteile miteinander verbunden, deren Lage durch einen Winkel $\phi$ in der x-y-Ebene bestimmt ist. Die geraden Leiterteile der beiden Elementar-Sattelspulen liegen wenigstens annähernd aneinander, die hinteren Bogen der beiden Elementar-Sattelspulen liegen ebenfalls wenigstens annähernd aneinander. Jede Elementarsattelspule hat eine vorbestimmte Amperewindungszahl.

Es sind Geräte zum Erzeugen von Schnittbildern eines Untersuchungsobjektes, vorzugsweise eines menschlichen Körpers, bekannt, deren Wirkungsweise auf magnetischer Kernresonanz beruht. Diese sogenannten Kernspintomographen enthalten einen Grundfeldmagneten, der die Kernspins im menschlichen Körper ausrichtet, und ferner ein Hochfrequenzsystem zur Anregung der Kernspins und zum Empfang der von den angeregten Kernspins emittierten Signale. Für die Schichtselektion und die räumliche Zuordnung der Signale in der Schicht sind ferner Gradientenfelder erforderlich. Das Gradientenspulen-System enthält Gradientenspulen, die ein in Richtung des Grundfeldes verlaufendes und sich in dieser Richtung linear änderndes Magnetfeld erzeugen. Weitere Gradientenspulen erzeugen ebenfalls ein in Richtung des Grundfeldes verlaufendes Magnetfeld, das sich jedoch in zwei dazu senkrechten Richtungen ändert. Durch Erregung dieser Gradientenspulen wird die Phase des im Anschluß an die Erzeugung des Grundfeldes in dem Hochfrequenzsystem induzierten Signals in Abhängigkeit von der Kernspinverteilung in dem untersuchten Körperbereich beeinflußt, so daß es möglich ist, aus der Kern-Kernspinverteilung ein Bild einer Schnittebene des Körpers abzuleiten.

Für die bildgebende Kernspinresonanz sind somit neben dem Grundfeld $\vec{B} = B_o \cdot \vec{e}_z$ und einem Hochfrequenzfeld $\vec{B}_{x,y}$ auch die unabhängig voneinander schaltbare Gradientenfelder erforderlich, die jeweils ein möglichst lineares Feldgradientenfeld

$$G_x = \frac{\partial B_z}{\partial x} \; ; \; G_y = \frac{\partial B_z}{\partial y} \; \text{und} \; G_z = \frac{\partial B_z}{\partial z}$$

erzeugen. Das y-Gradientenfeld ist dabei schwierig herzustellen, da es nicht rotationssymmetrisch ist. Das x-Gradientenfeld wird von einem Spulensystem erzeugt, das dem y-Gradientenfeld gleicht und nur um $90^\circ$ um die z-Achse verdreht montiert wird. Die wirksame z-Komponente des Feldes eines y-Gradientenfeldes läßt sich am besten darstellen in einer Reihenentwicklung nach Kugelfunktionen:

$$B_z(r, \vartheta, \varphi) = G_y R \sum_{n=1,3,\ldots}^{\infty} \left(\frac{r}{R}\right)^n \sum_{m=1,3\ldots}^{n} C(n,m) P_n^m(\cos\vartheta) \sin m\varphi$$

Die spezielle Symmetrie läßt nur ungerade Indices und sin-Terme zu.

Darin ist

n Grad der Legendre-Polynome

m Ordnung der Legendre-Polynome

$r = \sqrt{x^2 + y^2 + z^2}$

$\phi$ Winkel des Aufpunkts gegen x-Achse

$\vartheta$ Winkel des Aufpunkts gegen z-Achse

R Radius des Abbildungsbereichs

$\rho$ Radius des zylinderförmigen Trägerkörpers der Sattelspulen

$G_y$ Gradientenstärke, beispielsweise etwa 1 bis 10 mT/m

$\overline{P}^m_n$ Assoziierte Legendre-Polynome, normiert

C(n,m) Entwicklungskoeffizienten = relative Amplituden des Feldbeitrages vom Typ (n,m)

Die Normierung der Legendre-Polynome $\overline{P}^m_n$ wird so gewählt, daß sie Maximalwerte von etwa 1 annehmen. Dann stellen die Entwicklungskoeffizienten C(n,m) annähernd den Maximalbeitrag dar für Punkte auf einer Kugeloberfläche mit dem Radius R.

Ein ideales $G_y$-Spulensystem würde einzig und allein den Term C(1,1) = 1,1545 liefern. Da die Platzverhältnisse in einem Grundfeldmagneten für die Kernspintomographie sehr beengt sind, werden die Gradientenspulen im allgemeinen auf zylindrischen Trägerkörpern endlicher Länge aufgebaut. Dadurch entstehen höhere Störterme C(n,m), n>1, m>1. Dabei sind die Beiträge mit niedrigem n,m besonders störend, weil sie nur mit der n-ten Potenz in r zum Zentrum hin abnehmen. Störungen hohen Grades n sind eher zu akzeptieren, da sie sich nur am Rande des Nutzvolumens auswirken. Es soll somit eine Gestaltung der Gradientenspulen gefunden werden, bei denen bei konstantem C(1,1) möglichst viele Entwicklungskoeffizienten C(n,m) Null sind.

Eine bekannte Ausführungsform eines Kernspintomographen enthält ein System aus Gradientenspulen, die einen Hohlzylinder mit dem Radius $\rho$ nachbilden, dessen Zylinderachse in z-Richtung eines rechtwinkligen x-y-z-Koordinatensystems mit dem Koordinatenursprung im Zentrum eines Abbildungsbereiches verläuft. In dieser Richtung erstreckt sich auch das magnetische Feld $B_z$ eines Grundfeldmagneten. Zum Erzeugen eines im Abbildungsbereich wenigstens annähernd konstanten z-Gradienten sind wenigstens zwei ringförmige, symmetrisch zur x-y-Ebene angeordnete und gegensinnig stromdurchflossene Einzelspulen vorgesehen. Ferner enthält das Gradientenspulen-System mindestens je einen Satz von bezüglich der Symmetrieebene wenigstens annähernd symmetrisch angeordnete Paare von sattelförmigen Einzelspulen, die im Abbildungsbereich einen weitgehend konstanten x-Gradienten

$$G_x = \frac{\partial B_z}{\partial x}$$

und einen entsprechenden y-Gradienten

$$G_y = \frac{\partial B_z}{\partial y}$$

erzeugen. Diese Sattelspulen enthalten jeweils gerade, in z-Richtung verlaufende Spulenteile und azimutal zur z-Achse in Umfangsrichtung des Zylinders verlaufende Spulenteile. In den einander benachbarten geraden Spulenteilen der beiden Elementarsattelspulen sind die Stromflußrichtungen gleich. Die Stromflußrichtungen sind jedoch ebenfalls gleich in den entsprechenden, symmetrisch bezüglich der Symmetrieebene angeordneten bogenförmigen Spulenteilen des anderen Spulenpaares. Die Spulenbogen sind in vorbestimmten Abständen von der Symmetrieebene angeordnet und mit zunehmendem Abstand von der Symmetrieebene hat die Durchflutung in den Spulenbogen größere Werte. Durch diese Aufspaltung derjenigen Spulen, die der Symmetrieebene benachbart sind (split arc saddle coils), sind wesentliche Störterme C eliminiert (US-Patent 4 486 711).

Der Erfindung liegt die Aufgabe zugrunde, diese bekannte Ausführungsform eines Kernspintomographen mit einem Gradientenspu len-System, das sattelförmige Hauptspulen enthält, weiter zu verbessern, insbesondere sollen weitere Störterme der Gradientenfelder eliminiert werden.

Diese Aufgabe wird erfindungsgemäß gelöst mit den kennzeichnenden Merkmalen des Anspruchs 1. Durch diese Zusatzspulen werden auch noch weitere Störterme eliminiert. Weitere besonders vorteilhafte Ausgestaltungen des Gradientenspulen-Systems gehen aus den Unteransprüchen hervor.

Zur weiteren Erläuterung der Erfindung wird auf die Zeichnung Bezug genommen, in deren Figur 1 als Ausführungsbeispiel ein Teil eines bekannten Gradientenspulen-Systems mit den bekannten besonders gestalteten Sattelspulen gemäß dem Stand der Technik schematisch veranschaulicht ist. Eine Abwicklung in den z,$\phi$-Koordinaten zeigt Figur 2. In Figur 3 ist eine Ausführungsform des Gradientenspulen-Systems gemäß der Erfindung als Schnitt senkrecht zur z-Achse des Koordinatensystems dargestellt. In Figur 4 ist diese Ausführungsform als Teil einer Abwicklung in den z,$\phi$-Koordinaten veranschaulicht. Die Figuren 5 und 6 zeigen jeweils eine weitere Ausführungsform des Gradientenspulen-Systems als Abwicklung.

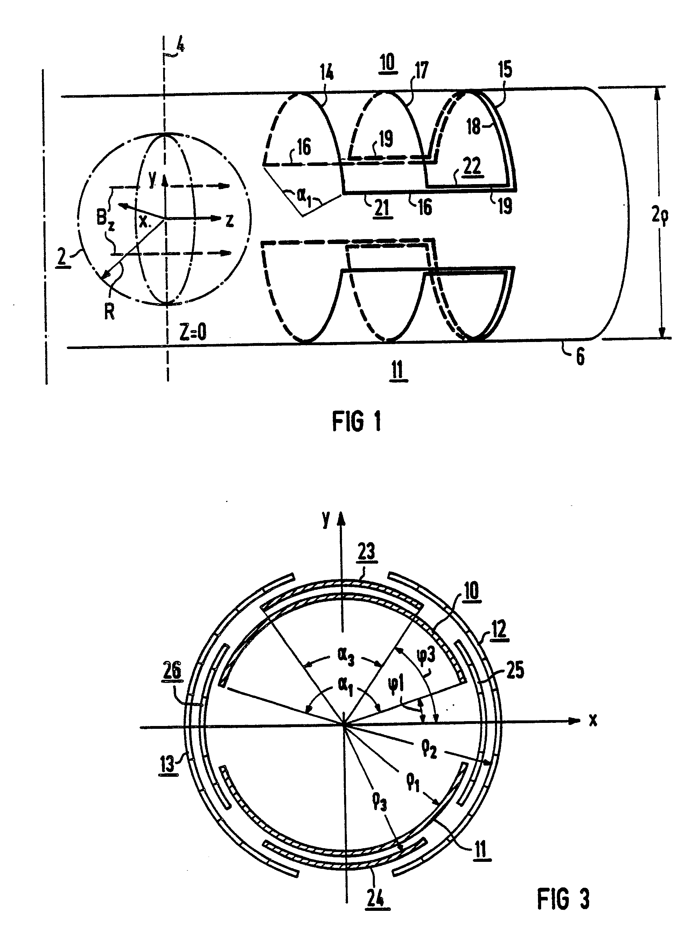

In der Ausführung eines Gradientenspulen-Systems gemäß Figur 1 soll ein in bekannter Weise aufgebauter und deshalb in der Figur nicht dargestellter, vorzugsweise supraleitender Magnet ein magnetisches Grundfeld $B_z$ in der Z-Richtung eines rechtwinkligen x-y-z-Koordinatensystems erzeugen. Das Gradientenspulen-System erzeugt wenigstens annähernd konstante magnetische Feldgradienten in einem Abbildungsbereich 2, der in der Figur als im wesentlichen kugelförmig mit dem Radius R angenommen ist. Im Zentrum des Abbildungsbereiches 2 befindet sich der Koordinatenursprung des Koordinatensystems. Eine zu untersuchende Probe, vorzugsweise ein menschlicher Körper, wird längs der Z-Achse in das Magnetfeld $B_z$ eingebracht. Die Anregung der Kernspins erfolgt mittels eines in der Figur nicht dargestellten senkrecht zur Z-Achse gerichteten Hochfrequenzfeldes einer Hochfrequenz-Antenne, die zugleich als Empfänger zur Aufnahme der Kernspinresonanzsignale dienen kann.

Das Gradientenspulen-System soll zur Erzeugung des z-Gradienten beispielsweise in der Figur nicht dargestellte ringförmige Spulen mit dem Durchmesser $2\rho$ enthalten, die in bekannter Weise jeweils beiderseits einer Symmetrieebene, der x-y-Ebene, angeordnet sind, die in der Figur gestrichelt angedeutet und mit 4 bezeichnet ist. Das Gradientenspulen-System umfaßt ferner Gradientenspulen für ein x-Gradientenfeld und ein y-Gradientenfeld in der Ausführungsform als Sattelspulen, von denen in der Figur zur Vereinfachung nur der Teil des rechts von der Symmetrieebene 4 angeordneten Teilsystems zur Erzeugung des y-Gradientenfeldes in Schrägansicht schematisch veranschaulicht ist. Verdeckte Leiterteile sind dabei in der Figur durch gestrichelte Linien angedeutet. Das Spulensystem, mit dem im Abbildungsbereich wenigstens annähernd lineare Gradientenfelder in y-Richtung erzeugt werden sollen, umfaßt zwei Paare von y-Hauptspulen, von denen nur das rechts von der Symmetrieebene 4 angeordnete Paar in der Figur dargestellt und mit 10 und 11 bezeichnet ist. Diese y-Hauptspulen 10 und 11 sind symmetrisch zur x-z-Ebene auf einem hohlzylindrischen Trägerkörper 6 angeordnet, dessen Radius beispielsweise $\rho$ = 0,37 m betragen soll und dessen Zylinderachse in z-Richtung des dargestellten Koordinatensystems im Abbildungsbereich 2 verläuft. In diesem Bereich ist das wirksame Grundfeld $B_z$ mindestens annähernd homogen.

Um eine gemäß den Homogenitätsforderungen der Kernspinresonanztechnik ausreichende Linearität der Gradientenfelder, beispielsweise des y-Gradientenfeldes zu gewährleisten, enthält die y-Hauptspule 10 zwei Elementarsattelspulen 21 und 22 mit einer vorbestimmten Amperewindungszahl. Die Länge der Spulen bogen 14 und 15 wird dabei vorzugsweise so gewählt, daß sich ein Öffnungswinkel $\alpha_1$ zwischen etwa 121° und 134° ergibt. Diese Spulenbogen 14 und 15 sind durch gerade, in z-Richtung verlaufende Leiterteile 16 derart miteinander verbunden, daß die Elementarsattelspule 21 entsteht. In gleicher Weise wird durch gerade Spulenteile 19 zwischen den Bogen 17 und 18 die Elementarsattelspule 22 gebildet. Die beiden Elementarsattelspulen 21 und 22 liegen räumlich ineinander und sind elektrisch vorzugsweise in Serie geschaltet. Die zweite y-Hauptspule 11 ist in gleicher Weise aufgebaut.

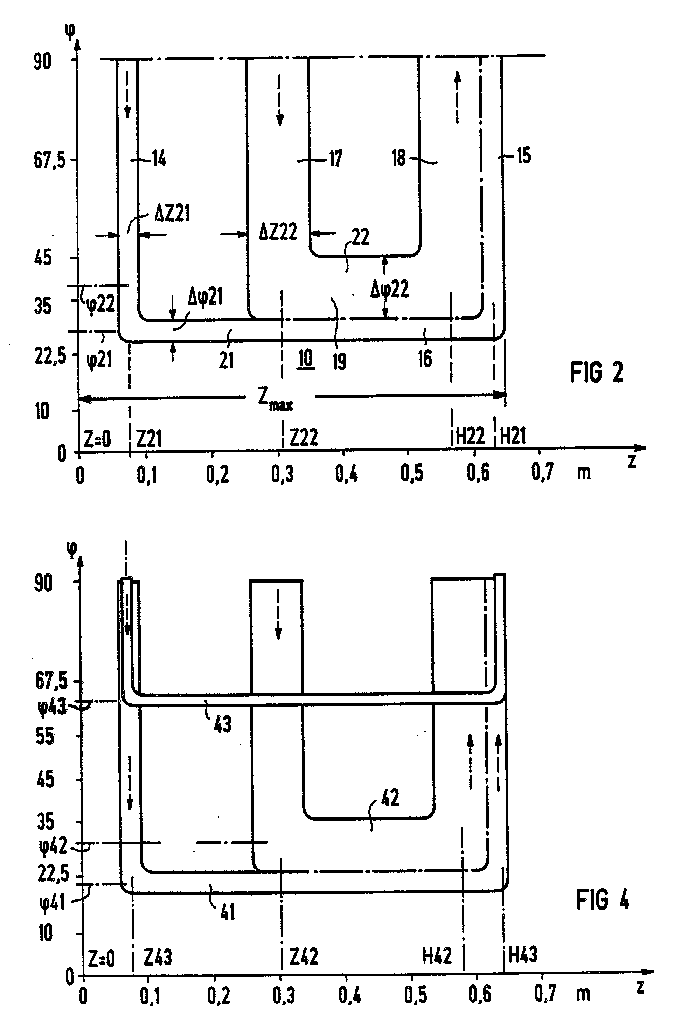

Da die y-Hauptspulen 10 und 11 symmetrisch zur y-z-Ebene angeordnet sind, genügt zur Betrachtung der besonderen Ausführungsform des Gradientenspulen-Systems eine Abwicklung in z-$\phi$-Koordinaten einer Hälfte der Hauptspule gemäß Figur 2, wobei $\phi$ der Winkel gegen die x-Achse ist. Die Hauptspule 10 besteht aus den Elementarsattelspulen 21 und 22. Für eine Berechnung dieser Elementarsattelspulen 21 und 22 soll beispielsweise eine Systemlänge von 2 $Z_{max}$ = 1,30 m und ein Strombelag von ca. 2 AT/mm angenommen werden, d.h. die Breiten $\Delta\rho21$ und $\Delta\phi22$ sowie $\Delta Z21$ und $\Delta Z22$ der Elementar-Sattelspulen entstehen aus den notwendigen Amperewindungen AT. Die räumliche Lage des vorderen Spulenbogens 14 der Elementarsattelspule 21 ist durch einen mittleren Abstand Z21 und die Lage des vorderen Spulenbogens 17 der Elementarsattelspule 22 mit in gleicher Weise durch einen mittleren Abstand Z22 von der x-y-Ebene (z = 0) gegeben. Der Abstand der hinteren Spulenbogen 15 und 18 dieser Elementarsattelspulen ist mit $H_{21}$ bzw. $H_{22}$ bezeichnet.

Gemäß der Erfindung wird nun den y-Hauptspulen jeweils eine ebenfalls sattelförmige y-Zusatzspule 23 bzw. 24 zugeordnet, wie es im Schnitt der Figur 3 veranschaulicht ist. Der Öffnungswinkel $\alpha_3$ ist kleiner als 90°. Die Lage der geraden Leiterteile der y-Zusatzspule 23 und damit die Länge der Spulenbogen werden bestimmt durch einen Winkel $\phi_3$ von der x-Achse, der größer ist als der Winkel $\phi_1$ der Hauptspule 10. Die y-Zusatzspulen 23 und 24 können vorzugsweise in einer Zylinderfläche angeordnet werden, deren Radius $\rho_3$ nur unwesentlich größer ist als der Radius $\rho_1$ der y-Hauptspulen 10 und 11.

In einer besonderen Ausführungsform des Gradientenspulen-Systems können auch x-Zusatzspulen 25 und 26, die den x-Hauptspulen 12 und 13 für einen x-Gradienten zugeordnet sind, in der gleichen Zylinderebene mit dem Radius $\rho_3$ angeordnet sein.

Eine Hauptspule gemäß Figur 2 läßt sich einfach berechnen aus den Leiterbogen mit dem Winkel $\phi$ und den geraden Spulenteilen in Richtung der z-Achse. Für einen Zylinderradius von beispielsweise $\rho$ = 0,37 m ergeben sich für die Ausführungsform der Elementarsattelspule 21 mit den Spulenbogen 14 und 15 und einer Systemlänge von $z_{max}$ = 0,65 m und einem Strombelag von ca. 2 AT/mm (ampere-turns) sowie einem Nutzgradienten G = 1 mT/m Spulendaten für das y-Gradientensystem, wie sie in der Tabelle I angegeben sind.

Darin sind AT 21 = 70,9 die Amperewindungen der Elementarsattelspule 21 und AT 22 = 191,4 die

4

Amperewindungen der Elementarsattelspule 22. Z21 = 75,4 mm ist der Abstand des vorderen Bogens 14 und Z22 = 305 mm der Abstand des Bogens 17 von der x-y-Ebene (z = 0). Ferner sind die Abstände H21 und H22 der hinteren Bogen sowie die Winkel Δ21 und Δ22 der geraden Leiterteile 16 bzw. 19 angegeben. Ferner ist das Spektrum der Störterme mit den Entwicklungskoeffizienten C(n,m) in normierten Kugelfunktionen bezogen auf einen Radius R = 0,25 m des Abbildungsbereiches 2 in % angegeben. Mit dieser bekannten Ausführungsform der y-Hauptspule 10 sind die Störterme C (5,1) und C (7,1) bereits eliminiert.

Die weiteren Störterme C (5,3) und C (5,5) lassen sich gemäß der Erfindung mit einer Elementarspule 43, die eine y-Zusatzspule 23 oder 24 darstellt, eliminieren, wie sie in Figur 4 veranschaulicht ist. Wie Tabelle II zu entnehmen ist, ergeben sich für diese Elementarsattelspule AT43 = 25,2 Amperewindungen und eine Position Z43 = 76,2 mm sowie eine Position H43 = 643,7 und ein Winkel φ 43 = 62,58˚. Die Dimensionierung der y-Hauptspule ändert sich gegenüber der Ausführungsform gemäß Figur 2. Die Elementarsattelspule 41 enthält dann AT41 = 54,2 Amperewindungen und eine Position Z41 = 74,9 mm sowie einen Winkel φ41 = 20,98˚. Mit dieser Ausführungsform werden auch noch die Störterme C (5,3), C (5,5) sowie C (7,3) eliminiert.

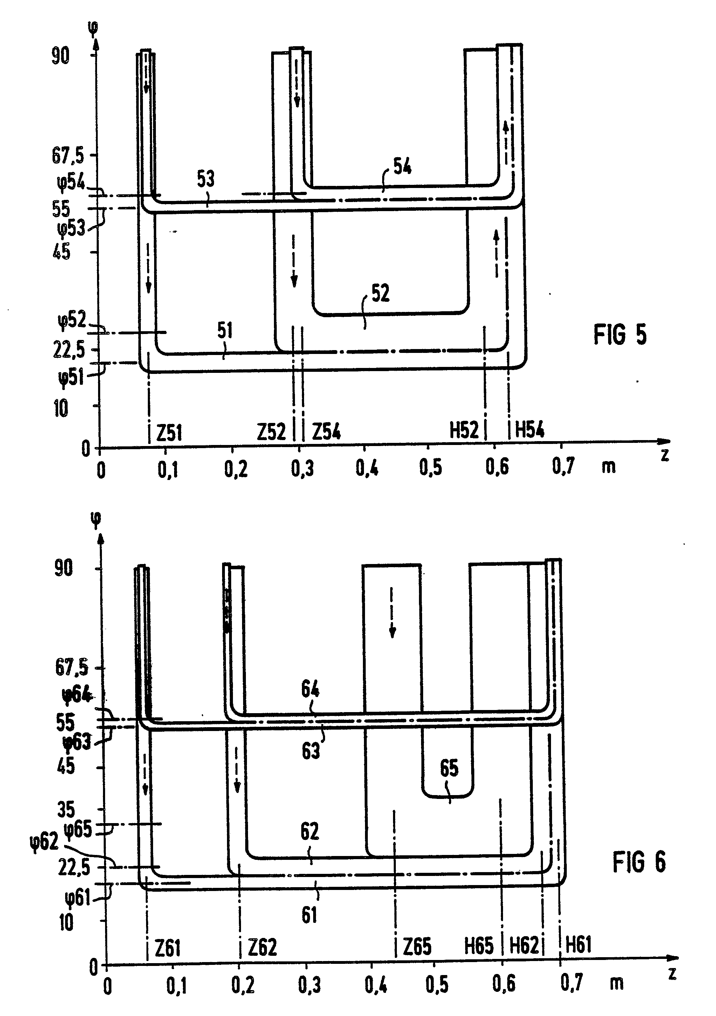

In der Ausführungsform gemäß Figur 5 sind Elementarsattelspulen 53 und 54, die ineinander liegen, als Zusatzspule vorgesehen. Damit ergeben sich gemäß Tabelle III AT53 = 28 Amperewindungen für die Elementarsattelspule 53 und ein Winkel φ 53 = 55,10˚, der geringfügig kleiner ist als der Winkel φ 54 = 57,63˚. Die Abmessungen und Amperewindungszahlen der Elementarsattelspulen 51 und 52 sind wiederum geändert gegenüber der Ausführungsform gemäß Figur 4. In dieser Ausführungsform des Gradientenspulensystems können auch noch die Störterme C (7,5) und C (7,7) eliminiert werden. Damit erhält man ein Spulensystem für den y-Gradienten, dessen Fehlerterme erst bei n = 9 der Kugelfunktionen beginnen. Der Systemfehler wird durch den Störterm C (9,1) = -1,21 bestimmt. Die dadurch entstehende Bildverzeichnung beträgt nur noch etwa 1 % am Rande des Abbildungsbereiches 2 und fällt mit der 9. Potenz des Abstandes zum Zentrum hin ab.

In einer besonderen Ausführungsform gemäß Figur 6 wird zu den Elementarsattelspulen 61 und 62 und den Elementarsattelspulen 63 und 64 der Zusatzspule noch eine Ergänzungsspule 65 hinzugefügt, die gemäß Tabelle IV AT 65 = 247 Amperewindungen enthält. Sie ist in die Elementarsattelspule 62 derart eingelegt, daß ihr hinterer Bogen wenigstens annähernd dem hinteren Bogen der Elementarsattelspule 62 und ihre geraden Leiterteile wenigstens annähernd an den geraden Leiterteilen der Elementarsattelspule 62 anliegen. Sie ist in der gleichen Zylinderfläche der Elementarsattelspulen 61 und 62 der Hauptspule angeordnet. In dieser Ausführungsform eines Gradientenspulen-Systems bleibt gemäß Tabelle IV als Systemfehler im wesentlichen nur noch der Term C (9,9) = -0,22 übrig, der nur noch eine maximale geometrische Bildverzeichnung von etwa 0,2 % verursacht.

Dem Schnitt des Gradientenspulen-Systems gemäß Figur 3 ist zu entnehmen, daß die y-Hauptspulen 10 und 11 sowie die y-Zusatzspulen 23 und 24 für den y-Gradienten in zwei verschiedenen Zylinderflächen des Trägers 6 angeordnet sind. In der Zylinderfläche der y-Zusatzspulen 23 und 24 sind auch die x-Zusatzspulen 25 und 26 für den x-Gradienten angeordnet. Die x-Hauptspulen 12 und 13 für den x-Gradienten sind in einer dritten koaxialen Zylinderfläche angeordnet. Mit einem derartigen dreischaligen Aufbau für ein Gradientenspulen-System 9. Ordnung ergibt sich somit nur ein geringer räumlicher Mehrbedarf.

Im Ausführungsbeispiel gemäß Figur 3 sind die y-Hauptspulen 10, 11 auf dem kleineren Zylinderradius $\rho_1$ und die x-Hauptspulen 12 und 13 auf dem größeren Zylinderradius $\rho_2$ angeordnet. Damit ergeben sich für die x-Hauptspulen 12 und 13 etwas höhere Amperewindungszahlen AT. Die Anordnung dieser Spulen kann aber auch vertauscht werden und die x-Hauptspulen können somit auch auf dem kleineren Zylinderradius $\rho_1$ angeordnet werden.

Die in den Tabellen angegebenen Zahlenwerte beziehen sich auf den angenommenen Spulenradius $\rho$ = 0,37 m und die Stärke des Gradientenfeldes G = 1 mT/m. Für einen anderen Radius $\rho^1$ und einen anderen Nutzgradienten $G^1$ sind die in den Tabellen angegebenen Daten der Elementarsattelspulen nach den folgenden Skalierungsgesetzen zu ändern: $AT^1 = AT (\rho^1/\rho)^2 (G^1/G)$

$\phi^1 = \phi$

$Z^1 = Z (\rho^1/\rho)$

$H^1 = H (\rho^1/\rho)$

Im Ausführungsbeispiel ist zur Vereinfachung der Erläuterung die Anordnung der Gradientenspulen auf dem Trägerkörper 6 angenommen. Unter Umständen kann es zweckmäßig sein, das Gradientenspulen-System zu einer selbsttragenden Baueinheit zu vereinigen. Dann ist ein besonderer Trägerkörper überflüssig.

5

Tabelle I

| (zur Figur 2) | | | |
|---|---|---|---|
| y-Gradientenfelder | | Spektrum n,m | C(n,m) [%] |
| AT 21 | 70,9 A | 1,1 | 115,45 |
| Z 21 | 75,4 mm | 3,1 | 0,00 |
| H 21 | 632,3 mm | 3,3 | 0,00 |
| Phi 21 | 28,42 ˙ | 5,1 | 0,00 |
| AT 22 | 191,4 A | 5,3 | -1,33 |
| Z 22 | 305,0 mm | 5,5 | -2,98 |
| H 22 | 566,0 mm | 7,1 | 0,00 |
| Phi 22 | 38,82 ˙ | 7,3 | -0,05 |
| | | 7,5 | -0,24 |
| | | 7,7 | -1,11 |
| | | 9,1 | -1,17 |
| | | 9,3 | 0,14 |
| | | 9,5 | 0,12 |
| | | 9,7 | 0,14 |
| | | 9,9 | 0,16 |

Tabelle II

| (zur Figur 4) | | | |
|---|---|---|---|
| y-Gradientenfelder | | Spektrum n,m | C(n,m)[%] |
| AT 41 | 54,2 A | 1,1 | 115,45 |
| Z 41 | 74,9 mm | 3,1 | 0,00 |
| H 41 | 636,7 mm | 3,3 | 0,00 |
| Phi 41 | 20,98 ˙ | 5,1 | 0,00 |
| AT 42 | 163,4 A | 5,3 | 0,00 |
| Z 42 | 300,3 mm | 5,5 | 0,00 |
| H 42 | 582,0 mm | 7,1 | 0,00 |
| Phi 42 | 29,55 ˙ | 7,3 | 0,00 |
| AT 43 | 25,2 A | 7,5 | -0,29 |
| Z 43 | 76,2 mm | 7,7 | -0,57 |
| H 43 | 643,7 mm | 9,1 | -1,23 |
| Phi 43 | 62,58 ˙ | 9,3 | -0,03 |
| | | 9,5 | -0,13 |
| | | 9,7 | 0,01 |
| | | 9,9 | -0,33 |

EP 0 372 096 A1

Tabelle III

| (zur Figur 5) | | | |
|---|---|---|---|
| y-Gradientenfelder | | Spektrum n,m | Cn,m[%] |
| AT 51 | 48,6 | 1,1 | 115,45 |
| Z 51 | 75,1 | 3,1 | 0,00 |
| H 51 | 637,9 | 3,3 | 0,00 |
| Phi 51 | 18,68 | 5,1 | 0,00 |
| AT 52 | 128,1 | 5,3 | 0,00 |
| Z 52 | 293,8 | 5,5 | 0,00 |
| H 52 | 594,5 | 7,1 | 0,00 |
| Phi 52 | 25,49 | 7,3 | 0,00 |
| AT 53 | 28,0 | 7,5 | 0,00 |
| Z 53 | 74,4 | 7,7 | 0,00 |
| H 53 | 642,9 | 9,1 | -1,21 |
| Phi 53 | 55,10 | 9,3 | 0,02 |
| AT 54 | 37,1 | 9,5 | -0,03 |
| Z 54 | 303,1 | 9,7 | 0,12 |
| H 54 | 626,7 | 9,9 | 0,22 |
| Phi 54 | 57,63 | | |

Tabelle IV

| (zur Figur 6) | | | |
|---|---|---|---|
| y-Gradientenfelder | | Spektrum n,m | C(n,m)[%] |
| AT 61 | 37,8 A | 1,1 | 115,45 |
| Z 61 | 60,1 mm | 3,1 | 0,00 |
| H 61 | 690,5 mm | 3,3 | 0,00 |
| Phi 61 | 18,14 ° | 5,1 | 0,00 |
| AT 62 | 53,4 A | 5,3 | 0,00 |
| Z 62 | 199,7 mm | 5,5 | 0,00 |
| H 62 | 667,0 mm | 7,1 | 0,00 |
| Phi 62 | 21,83 ° | 7,3 | 0,00 |
| AT 63 | 21,9 A | 7,5 | -0,03 |
| Z 63 | 57,3 mm | 7,7 | 0,00 |
| H 63 | 667,0 mm | 9,1 | 0,00 |
| Phi 63 | 54,56 ° | 9,3 | 0,01 |
| AT 64 | 22,3 A | 9,5 | -0,02 |
| Z 64 | 190,0 mm | 9,7 | 0,05 |
| H 64 | 685,0 mm | 9,9 | -0,22 |
| Phi 64 | 56,13 ° | | |
| AT 65 | 247,5 A | | |
| Z 65 | 442,5 mm | | |
| H 65 | 610,5 mm | | |
| Phi 65 | 31,67 ° | | |

**Ansprüche**

7

1. Gradientenspulen-System für einen Kernspintomographen, dessen Symmetrieebene in der x-y-Ebene eines rechtwinkligen x-y-z-Koordinatensystems liegt, dessen z-Achse in Richtung eines magnetischen Grundfeldes $B_z$ verlaüft, mit folgenden Merkmalen:

dem Grundfeld $B_z$ ist eine Sattelspulenanordnung für ein x-Gradientenfeld und eine Sattelspulenanordnung für ein y-Gradientenfeld zugeordnet,

die Sattelspulenanordnungen enthalten jeweils vier Hauptspulen, die aus Sattelspulen mit aufgeteiltem inneren Spulenbogen (split arc saddle coils) bestehen und auf jeweils der gleichen Mantelfläche eines Zylinders angeordnet sind,

die Hauptspulen bestehen jeweils aus zwei ineinanderliegenden Elementarsattelspulen,

jede Elementarsattelspule enthält einen der x-y-Ebene zugewandten, vorderen Spulenbogen mit dem Abstand Z von der x-y-Ebene und einen hinteren Spulenbogen mit dem Abstand H,

die Spulenbogen sind durch in z-Richtung verlaufende gerade Spulenteile miteinander verbunden, deren Lage durch einen Winkel $\phi$ in der x-y-Ebene bestimmt ist,

die geraden Spulenteile der beiden Elementarsattelspulen liegen wenigstens annähernd aneinander,

die hinteren Spulenbogen der beiden Elementarsattelspulen liegen ebenfalls wenigstens annähernd aneinander,

jede Elementarsattelspule hat eine vorbestimmte Amperewindungszahl AT (ampere turns),

**gekennzeichnet** durch folgende Merkmale:

den y-Hauptspulen (10, 11) ist jeweils ein Paar y-Zusatzspulen (23, 24) und den x-Hauptspulen (12, 13) ist jeweils ein Paar x-Zusatzspulen (25, 26) zugeordnet, die als Sattelspulen ausgebildet sind,

der Öffnungswinkel $\alpha_3$ dieser Zusatzspulen (23 bis 26) ist kleiner als $90°$,

alle Zusatzspulen (23 bis 26) sind auf der gleichen Zylinderfläche mit dem Radius $\rho_3$ angeordnet,

die Zusatzspulen (23 bis 26) sind jeweils winkelzentriert zur zugeordneten Hauptspule (10, 11 bzw. 12, 13) angeordnet,

die das Gradientenfeld bestimmenden Größen (AT, Z, H, $\phi$) jeder einzelnen Elementarsattelspule (41, 42) der Hauptspulen (z.B. 10 und 11) und der Elementarsattelspulen (43) der Zusatzspulen (23 bis 26) sind so aufeinander abgestimmt, daß die Störterme C(n,m) der Reihenentwicklung des Gradientenfeldes weitgehend eliminiert werden (Figur 4, Tabelle II).

2. Gradientenspulen-System nach Anspruch 1, **dadurch gekennzeichnet,** daß die Elementarsattelspulen (53, 54) der y-Zusatzspulen (23, 24) als Sattelspulen mit aufgeteilten Bogen (split arc saddle coils) ausgebildet sind (Figur 5; Tabelle III).

3. Gradientenspulen-System nach Anspruch 1 oder 2, **dadurch gekennzeichnet,** daß den Elementarsattelspulen (61, 62) der y-Hauptspulen, denen jeweils eine Ergänzungsspule (65) zugeordnet ist, die als Elementarsattelspule ausgebildet ist und mit den Elementarsattelspulen (61, 62) in der gleichen Zylinderfläche $\rho_1$ angeordnet ist, und deren hinterer Spulenbogen wenigstens annähernd am hinteren Spulenbogen der inneren Elementarsattelspule (62) und deren gerade Spulenteile an den geraden Spulenteilen der inneren Elementarspule (62) anliegen (Figur 6; Tabelle IV).

FIG 1

FIG 3

FIG 2

FIG 4

FIG 5

FIG 6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EP-A-0 274 149 (N.V. PHILIPS' GLOEILAMPENFABRIEKEN) * Spalte 3, Zeile 23 - Spalte 6, Zeile 9; Figuren 2a,2b * | 1,2 | G 01 R 33/20 |
| A | EP-A-0 243 270 (COMMISSARIAT A L'ENERGIE ATOMIQUE) * Seite 3, Zeile 17 - Seite 5, Zeile 42; Figuren 1,4-9 * | 1,2 | |
| A | EP-A-0 222 649 (THOMSON-CGR) * Seite 3, Zeile 28 - Seite 4, Zeile 56; Figuren 1-3 * | 1,2 | |
| A | GB-A-2 170 957 (OXFORD MAGNET TECHNOLOGY LTD) * Seite 2, Zeilen 15-109; Figuren 1-5 * | 1,2 | |
| A | EP-A-0 140 259 (GENERAL ELECTRIC CO.) * Seite 8, Zeile 19 - Seite 10, Zeile 19; Seite 22, Zeilen 18-33; Seite 24, Zeilen 22-34; Figuren 1,2,16 * | 1,2 | RECHERCHIERTE SACHGEBIETE (Int. Cl.5) |
| A | EP-A-0 221 810 (THOMSON-CGR) * Seite 4, Zeile 21 - Seite 5, Zeile 19; Figuren 1,2,4 * | 1,2 | G 01 N G 01 R H 01 F |
| A | EP-A-0 073 402 (SIEMENS AG) * Seite 4, Zeilen 14-31; Seite 7, Zeile 11 - Seite 11, Zeile 19; Figur 1 * & US-A-4 486 711 (Kat. A,D) | 1,2 | |

Der vorliegende Recherchenbericht wurde für alle Patentansprüche erstellt

| Recherchenort | Abschlußdatum der Recherche | Prüfer |
|---|---|---|
| DEN HAAG | 14-07-1989 | HORAK G.I. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
........................................................
& : Mitglied der gleichen Patentfamilie, übereinstimmendes Dokument

EPO FORM 1503 03.82 (P0403)